# EUROPEAN PATENT APPLICATION

(11) **EP 4 390 427 A1**
(43) Date of publication of application: **26.06.2024**
(21) Application number: 22214421.4
(22) Date of filing: 19.12.2022
(51) Int. Cl.: G01R 33/28, H02H 7/00, G01R 33/38, G01R 33/3815, H01F 6/02

(54) **AUTOMATED QUENCHING SYSTEM FOR MAGNETIC RESONANCE IMAGING**

(71) Applicant: Koninklijke Philips N.V., 5656 AG Eindhoven (NL)
(72) Inventor: FORTHMANN, Peter, Eindhoven (NL); MULDER, Gerardus Bernardus Jozef, Eindhoven (NL)
(74) Representative: Philips Intellectual Property & Standards

(57) **Abstract**

Disclosed herein is a medical system (100, 200, 300, 400) comprising a magnetic resonance imaging magnet (102) configured for generating a main magnetic field with a superconducting coil (108). The superconducting coil is cooled by a cryogenic chamber (106). The medical system further comprises a manual quenching system (112) configured for initiating a quench of the main magnetic field. The manual quenching system comprises at least one manual switch (114) configured for triggering the manual quenching system. The medical system further comprises at least one sensor (118, 202,478, 480) configured for providing sensor data (463). The medical system further comprises an automated quenching system (120) configured for triggering the manual quenching system in response to receiving the sensor data.

## Description

### FIELD OF THE INVENTION

The invention relates to magnetic resonance imaging, in particular to safety of magnetic resonance imaging magnets.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field. A hazard of using MRI scanners is that ferromagnetic objects such as tools and emergency response equipment can be attracted to the magnet.

In "Safety Guidelines for Magnetic Resonance Imaging Equipment in Clinical Use," February 2021, Medicines and Healthcare products Regulatory Agency (United Kingdom), https:llassets.publishing.service.gov. ukl government/uploads/system/uploads/attachment data/file/958486 IMRI guidance 2021-4-03c.pdf, a number of safety considerations associated with magnetic resonance imaging magnets are discussed. In §5.5.4 of this report the quenching of superconducting magnets and emergency quench buttons are discussed.

### SUMMARY OF THE INVENTION

The invention provides for a medical system, a computer program, and a method in the independent claims. Embodiments are given in the dependent claims.

The invention provides for a medical system, a computer program, and a method in the independent claims. In one aspect the invention provides for a medical system that comprises a magnetic resonance imaging magnet that is configured for generating a main magnetic field with a superconducting coil. The superconducting coil is cooled by a cryogenic chamber. The medical system further comprises a manual quenching system that is configured for initiating a quench of the main magnetic. The manual quenching system comprises at least one manual switch configured for triggering the manual quenching system.

The medical system further comprises at least one sensor configured for providing sensor data. The medical system further comprises an automated quenching system that is configured for triggering the manual quenching system in response to receiving the sensor data. This embodiment may be beneficial because there may be situations where the safety of the medical system is improved by having the magnetic resonance imaging magnet quenched but it is not able to be quenched by a person activating the manual quenching system.

In one embodiment the manual quenching system that is configured for initiating a quench of the main magnetic field by warming a portion of the cryogenic chamber Typically a manual quenching system will be directed by having a heater that is present in the cryogenic chamber. When the heater is activated, it warms a small portion of the cryogenic chamber which then initiates a chain reaction and the entire magnet begins quenching.

There are alternatives to using a heater or several heaters to initiate the quench. One alternative is adding increased magnetic field at some strategic points to propel the wire out of the superconducting zone. One could also let air into the cryostat by opening a valve and heat up the magnet. Another alternative is to introduce a burst of current in the magnet that initiates the quench. In various embodiments the automated quenching system could include a local computational system which uses logic to control when the automated quenching system quenches or triggers the manual quenching system or there could be a system of relays or other electrical components which automatically trip or activate the manual quenching system when one of the at least one sensor is triggered.

Magnetic resonance imaging magnets attract ferrous objects so forcefully that the accelerated objects can become a danger to any nearby individuals. In the case that some catastrophic event (earthquake, flood, fire, detonation) causes a collapse of an MRI room, a magnet at field that is buried underneath a pile of rubble poses a danger to people who are not aware of the magnetic field. This can be either because they are not knowledgeable about it, like 99.9% of the population, or simply because the magnet is hidden. Anybody with a shovel trying to search for survivors is then carrying a potential projectile.

Embodiment may have the benefit of reducing or eliminating the potential danger of people getting hurt due to acceleration of ferromagnetic objects in case they are unaware of the danger posed by an unquenched magnetic resonance imaging magnet.

In some embodiments, the magnetic resonance imaging magnet may be such down upon detection of a catastrophic event using the sensor data. The detection could encompass acoustic, thermal, optical, and mechanical (shock/acceleration) sensors located in strategic places and connected logically in a way to detect if the magnet gets buried or covered in another way. In that case, a magnet shut down (ERDU) would be triggered by the logic, which would eliminate the danger of magnetic field within a couple of seconds.

The safety mechanism may be a standalone component in some embodiments for safety reasons. In some embodiments the automated quenching system is powered by the ERDU batteries, so that it functions even if the power goes out due to destruction (even short ride-through magnets can stay at field without power for some hours).

In another embodiment the automated quenching system further comprises a local computational system and a local memory. The local memory comprises or stores the local machine-executable instructions. Execution of the local machine-executable instructions further causes the computational system to receive the sensor data. Execution of the local machine-executable instructions further causes the computational system to trigger the manual quenching system if the sensor data meets a pre-programmed trigger criterion. This embodiment may be beneficial because the local computational system may be used to receive data from multiple sensors as well as have complex rules for when the automated quenching system triggers the manual quenching system. This may enable more complicated behaviors which may prevent the quenching of the magnetic resonance imaging magnet when it is not desirable or it is not safe.

In another embodiment the automated quenching system comprises a test mode controller. The automated quenching system is configured such that when the test mode controller is engaged triggering of the manual quenching system by the automated quenching system is disabled. This may be beneficial because it may be used to disable the automated quenching system, for example when a service is being performed on the magnetic resonance imaging magnet. This may also enable the testing of the automated quenching system without having to actually trigger the quenching of the magnetic resonance imaging magnet.

In various embodiments the test mode controller could be implemented in different ways. In some cases it may be a switch with or without a key, which may be used to essentially disable the automated quenching system. In other cases the test mode controller may for example be operated as a software switch or control from a user interface.

In another embodiment the automated quenching system further comprises a test mode indicator. The test mode indicator is configured to provide an alert when the sensor meets a pre-programmed trigger criterion and the test mode controller is engaged. This for example may be useful for testing the operation of the automated quenching system without having to trigger the magnetic resonance imaging magnet. For example, the sensor data could be provided or emulated and fed to the automated quenching system to trigger a simulated event which would require the quenching of the magnetic resonance imaging magnet. This may be very useful for testing the safety of the magnetic resonance imaging magnet.

In another embodiment the automated quenching system comprises a data interface. The data interface is configured for receiving changes to the pre-programmed trigger criterion. In some embodiments the automated quenching system could be implemented using a controller or other computational type device. The pre-programmed trigger criterion could for example be stored in the local memory. The data interface may provide a means for modifying the pre-programmed trigger criterion so that it may be tailored to a particular sensor configuration provided by the at least one sensor as well as to meet local safety needs.

The data interface could be provided in different ways. For example, in some instances the data interface could be a network interface into which a computer or other computational device is plugged in. In other cases, it may be a more conventional device such as a serial interface. In yet other examples, it could be a wireless connection that is for example provided by a Bluetooth connection. There may however be certain security benefits provided by a wired interface. For example, an RS232 interface or a serial interface could be protected manually by a locked system.

In another embodiment the medical system further comprises an examination room containing the magnet. The at least one sensor comprises a camera. The sensor data comprises image data acquired by the camera. The camera is configured for imaging at least a portion of the examination room. The local memory further comprises a subject recognition module configured for identifying humans in the image data. Execution of the local machine-executable instructions further causes the computational system to receive the image data from the camera.

Execution of the local machine-executable instructions further causes the computational system to receive an identification of humans in the image data by inputting the image data into the subject recognition module. The predetermined criteria comprise disabling the automated quenching system if the identification of humans in the image data is received. This may for example be useful in increasing the security of the automated quenching system to avoid harming humans by causing the quench. This may for example be useful in situations where it may be unsafe to vent the gases produced by the quenching situation.

The subject recognition module may be implemented in different ways. There are a variety of neural network or algorithmic packages which are able to identify faces or other human features in an image. For example, neural networks which are able to put a bounding box around a face or a human subject are known. Also, neural network or algorithms which are able to identify key points of a subject are also known. Using a subject recognition module that uses key points may have the benefit of providing information about where the person is and also in terms of their body position. For example, a key point indicator or other subject recognition module may be used to identify when a subject is in the magnet so that a quench can be prevented when the person is actually physically in the bore of a magnet.

The subject recognition module could be implemented as a convolutional neural network that is trained to either identify the presence of a human in the input image or to identify the location of a human in the input image. The subject recognition module may be trained, for example using a deep learning algorithm that uses labeled image files.

In another embodiment the sensor comprises an accelerometer. The use of an accelerometer may be useful because it may, for example, be useful for detecting when the magnetic resonance imaging magnet is being shaken such as when there is an earthquake.

In another embodiment the at least one sensor further comprises an acoustic sensor. The use of an acoustic sensor may for example be beneficial when there is an explosion or also if there is some catastrophic event such as an earthquake.

In another embodiment the sensor further comprises a smoke detector. This may for example be useful in detecting when there is a fire in the vicinity of the magnetic resonance imaging magnet.

In another embodiment the at least one sensor further comprises a building power sensor. This for example may be connected to the power grid and/or the backup power generator for a hospital or other medical facility. If there has been a catastrophic loss of power also including the backup power, then it may be beneficial to quench the magnet for safety reasons.

In another embodiment the at least one sensor further comprises a thermal detector. The thermal detector in contrast to the smoke detector is used to detect temperatures above a certain amount. This may also be useful for detecting a fire. The combination of a smoke detector and a thermal detector may also be a better indicator if there is a threat to the magnetic resonance imaging system which should require a quench.

In another embodiment the at least one sensor further comprises a vibration sensor. As with the accelerometer, the vibration sensor may be useful in detecting a situation when there has been a severe accident with the magnetic resonance imaging magnet. The vibration sensor may also be useful in situations where a large magnetic object has come into contract or been drawn into the magnet.

In another embodiment the at least one sensor further comprises a moisture sensor. This may be useful if there is water in the vicinity of the magnetic resonance imaging magnet. This may for example be useful in avoiding electrical shock to individuals. This way the power can be removed from the magnet.

In other embodiments there are combinations of the above-mentioned sensors. The combinations of the various sensors may provide more information and provide for safer conditions when used together.

In another embodiment the medical system further comprises a venting duct configured for venting gases when the magnet quenches. The at least one sensor comprises a venting duct integrity detector configured for providing a duct signal that indicates if the venting duct is functional or non-functional. The automated quenching system is further configured for disabling triggering of the manual quenching system if the duct signal indicates that the venting duct is non-functional. This embodiment may for example be beneficial because if the magnet is quenched and the venting duct is non-functional, then the room in which the magnetic resonance imaging magnet is located could wind up producing gases that fill the room. The use of the venting duct integrity detector may therefore improve the safety of using an automated quenching system.

In another embodiment the venting duct integrity detector comprises a fiber-optic sensor comprising a fiber-optic cable attached to at least a portion of the venting duct. The automated quenching system is configured such that mechanical damage to the fiber-optic cable causes the duct signal to change from a functional to non-functional state. For example, if the fiber-optic is attached to or runs the length or a portion of the length of the venting duct, then if the venting duct is damaged this may cause damage to the fiber-optic cable or cause it to sever, which would then cause the venting duct integrity detector to indicate that the venting duct is non-functional. This may be a useful means of detecting if the venting duct is operational without having to measure the flow of gas through the venting duct.

In another embodiment the venting duct integrity detector comprises a conductive loop attached to at least a portion of the venting duct. The automated quenching system is configured such that a break in the conductive loop causes the duct signal to change from functional to non-functional. The conductive loop could for example be constructed from a thin wire that is easily damaged mechanically. This may mean that if the venting duct is compromised such as during an earthquake or situations where there may be other mechanical damage such as the partial collapse of a building during a fire, that the conductive loop would have its circuit broken and thus cause the venting duct integrity detector to indicate that the venting duct is non-functional.

In another embodiment the medical system further comprises a magnetic resonance imaging system. The magnetic resonance imaging system comprises the magnetic resonance imaging magnet, the manual quenching system, the at least one sensor, and the automated quenching system. The magnetic resonance imaging system further comprises a main memory configured for storing machine-executable instructions and pulse sequence commands. The pulse sequence commands are configured to control the magnetic resonance imaging system to acquire k-space data descriptive of a subject. The magnetic resonance imaging system further comprises a main computational system. Execution of the machine-executable instructions causes the main computational system to acquire the k-space data by controlling the magnetic resonance imaging system with the pulse sequence commands.

Execution of the machine-executable instructions further causes the computational system to preferably reconstruct the magnetic resonance image from the k-space data. The magnetic resonance image may be reconstructed from the k-space data by the main computational system. In other examples, the main computational system may send the k-space data to a remote or cloud-based computing system to perform the reconstruction.

In another embodiment the automated quenching system is logically isolated from the main memory and the main computational system. That is to say there is no means of exchanging data between the main computational system and the local computational system. This may for example be beneficial in improving the security of the automated quenching system. If the automated quenching system is not connected to the internet or to the main computational system this may prevent the automated quenching system from being hacked or for the automated quenching system from being activated remotely.

In another embodiment the at least one sensor comprises at least one switch mounted on a top portion of the magnet. Mounting a switch on the top portion of the magnet may be useful in several situations. In some cases, the at least one switch mounted on the top portion of the magnet may be activated manually. For example, if there is an unsafe situation during servicing of the magnetic resonance imaging magnet it may be easier for service personnel to activate a switch mounted on the top portion of the magnet. In other situations, putting a switch on the top portion of the magnet may be activated when something falls on the magnet. For example, when there is a collapse of the ceiling.

It should also be noted that in this embodiment the at least one switch mounted on the top portion of the magnet may be used to trigger it in combination with the local computational system. In other examples, there does not need to be a local computational system. The automated quenching system in this case could comprise an additional switch, which is connected to the manual quenching system.

In another embodiment the automated quenching system further comprises a trigger mechanism mounted on the top portion of the magnet. The trigger mechanism is configured to activate the at least one switch when moved towards the magnet. In various embodiments this may take different forms. For example, the trigger mechanism may be, for example, a mechanical bar or pressure plate which is used to activate the at least one switch mounted on the top portion of the magnet when the trigger mechanism is moved or actuated. This may be particularly beneficial in being used to detect when an object falls on the magnetic resonance imaging magnet. The trigger mechanism could for example be used to trigger the quench when the ceiling collapses.

In another aspect the invention provides for a computer program that comprises local machine-executable instructions for execution by a local computational system that is integrated into a medical system. The medical system comprises a magnetic resonance imaging magnet that is configured for generating a main magnetic field with a superconducting coil. The superconducting coil is cooled by a cryogenic chamber. The medical system further comprises a manual quenching system that is configured for initiating a quench of the main magnetic field. The manual quenching system comprises at least one manual switch configured for triggering the manual quenching system.

The medical system further comprises at least one sensor configured for providing sensor data. The medical system further comprises an automated quenching system that is configured for triggering the manual quenching system in response to receiving the sensor data. Execution of the local machine-executable instructions causes the local computational system to receive the sensor data. Execution of the local machine-executable instructions further causes the local computational system to trigger the manual quenching system if the sensor data meets a pre-programmed trigger criterion. The advantages of this computer program have been discussed previously.

In another aspect the invention provides for a method of operating the medical system. The medical system comprises a magnetic resonance imaging magnet that is configured for generating a main magnetic field of the superconducting coil. The superconducting coil is cooled by a cryogenic chamber. The medical system further comprises a manual quenching system configured for initiating a quench of the main magnetic field. The manual quenching system comprises at least one manual switch configured for triggering the manual quenching system. The medical system further comprises at least one sensor configured for providing sensor data. The medical system further comprises an automated quenching system that is configured for triggering the manual quenching system in response to receiving the sensor data. The method comprises receiving the sensor data. The method further comprises triggering the manual quenching system if the sensor data meets a pre-programmed trigger criterion.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,
Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 illustrates a further example of a medical system;
Fig. 3 illustrates a further example of a medical system;
Fig. 4 illustrates a further example of a medical system; and
Fig. 5 shows a flow chart which illustrates a method of using the medical system of Fig. 2, 3, or 4.

### DETAILED DESCRIPTION OF EMBODIMENTS

Like numbered elements in these figures are either equivalent elements or perform the same function. Elements which have been discussed previously will not necessarily be discussed in later figures if the function is equivalent.

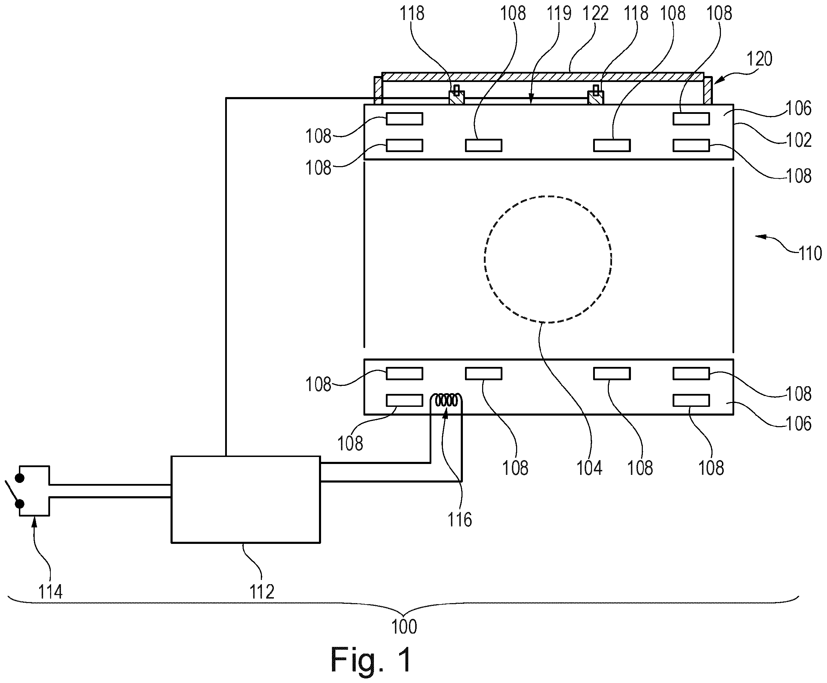

Fig. 1 illustrates an example of a medical system 100. The medical system 100 is shown as comprising a magnetic resonance imaging magnet 102. The magnetic resonance imaging magnet 102 is configured for generating a main magnetic field. There is an imaging zone 104 marked where the magnetic field is strong enough and uniform enough for acquiring k-space data during the magnetic resonance imaging protocol. The magnet 102 comprises a cryogenic chamber 106 or cryostat. Within the cryogenic chamber 106 there are a number of superconducting coils 108 used for generating the main magnetic field. In this example the magnet is a cylindrical type magnet with a bore 110. The invention may also apply to so called open magnets or other configurations. In some examples the cryogenic chamber 106 will be sealed and be a so called sealed magnet. In other cases the magnet needs to be replenished with liquid helium and liquid nitrogen at intervals.

The medical system 100 is further shown as comprising a manual quenching system 112 that has at least one manual switch 114 and e.g. a heater 116 within the cryogenic chamber 106. A small amount of heat will cause a portion of the cryogenic chamber 106 to approach temperatures where the superconducting no longer functions and the magnet 102 will then rapidly quench. The manual quenching system 112 may for example comprise a battery or other power supply for heating the switcher 116 and contain various switching electronics. In this example the manual switch 114 is shown as a normally open switch. This is only an example and in other examples the system 112 may operate with a normally closed switch.

The medical system 100 is further shown as comprising an automated quenching system 120. The automated quenching system 120 comprises a number of switches 118 mounted to a top region 119 of the magnet 102. The switches 118 are designed to be activated by a trigger mechanism. In this case the trigger mechanism is a pressure plate 122. If something presses or falls on top of the magnet 102 the pressure plate 122 will be depress one or both of the switches 118. The pressure plate 122 may be useful in situations where a service personnel needs to quench the magnet 102 rapidly.

Another situation would be if there is an earthquake and something falls from the ceiling and depresses the pressure plate 122. The pressure plate 122 could for example be a narrow strip that runs the length of the magnet 102. In this example the switches 118 are shown as going directly into the manual quenching system 112. In this case the automated quenching system 120 is essentially formed by the switches 118. These are switches 118 which may be operated automatically in the event of a catastrophe where objects are falling on the magnet 102. The manual quenching system 112 may be configured to receive a number of manual switches 114. The modification to add the automated quenching system 120 would be then to add the switches 118 on the top 119 of the magnet 102 in a manner that is equivalent to the manual switches 114.

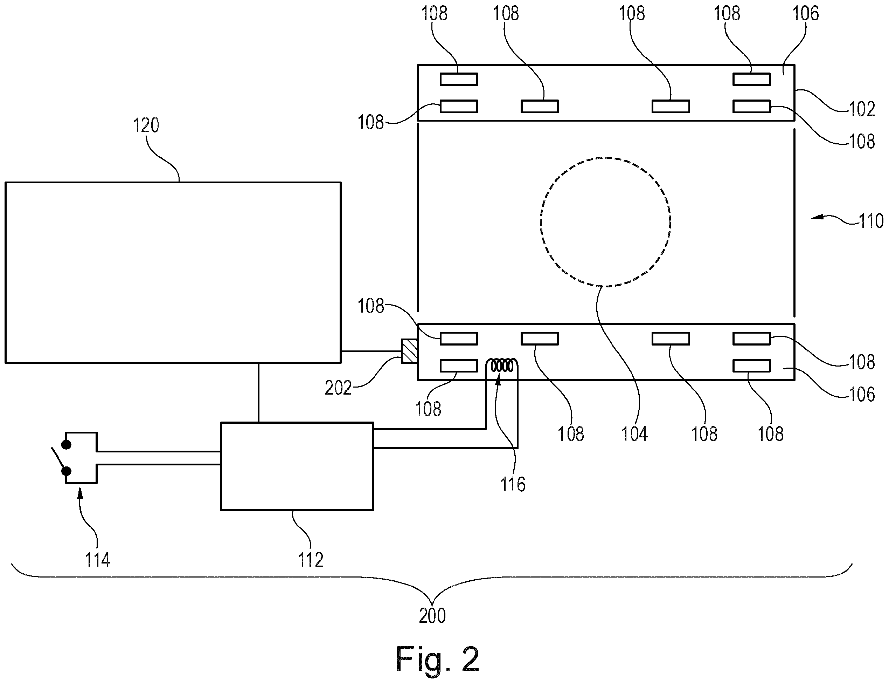

Fig. 2 illustrates a further example of a medical system 200. The medical system 200 illustrated in Fig. 2 is similar to the medical system 100 illustrated in Fig. 1. In this example the automated quenching system 120 is implemented as a controller and this is connected to a sensor package 202. The sensor package 202 may comprise at least one sensor configured for providing sensor data. The automated quenching system 120 is then configured for triggering the manual quenching system 112 in response to receiving the sensor data. The sensor package 202 may contain various types of sensors and may also be located on one or more locations on the magnet 102 or in its vicinity. In other examples the sensor package 202 could also be distributed throughout the building in which the magnet 102 is installed to measure other environmental or other data which is relevant to the safe operation of the magnet 102. The sensor package could contain one or more of the following:
an accelerometer, an acoustic sensor, a smoke detector, a building power sensor, a thermal detector, a vibration sensor, a moisture sensor, and combinations thereof. The automated quenching system 120 could for example send a signal or control voltage to the manual quenching system 112 to emulate one of the manual switches 114.

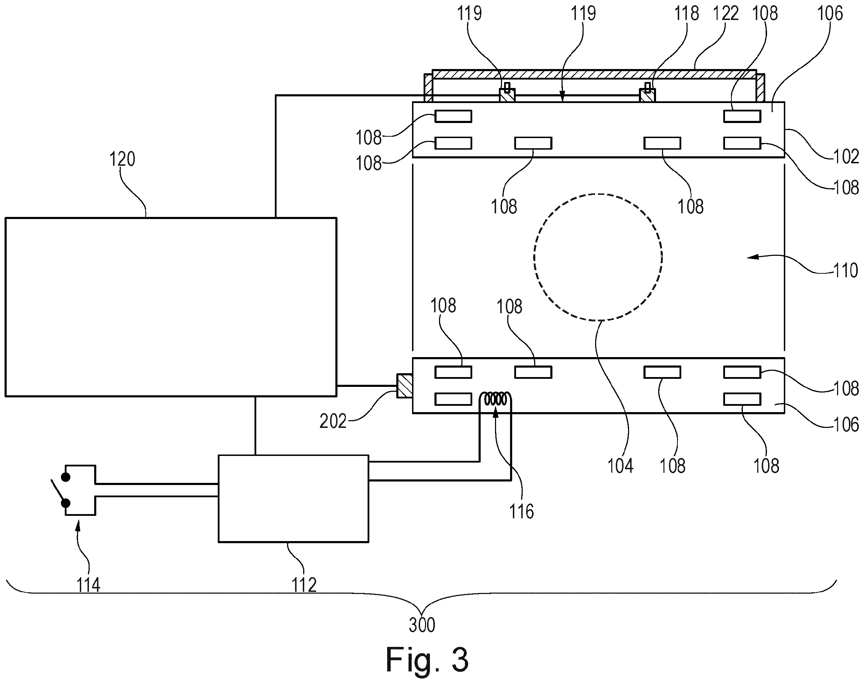

Fig. 3 illustrates a further example of a medical system 300. The example illustrated in Fig. 3 incorporates many features from both the medical system 200 depicted in Fig. 2 and the medical system 100 depicted in Fig. 1. The medical system 300 shows the automated quenching system 120 implemented as a controller. In this case the switches 118 mounted on the top 119 of the magnet 102 are connected to the automated quenching system 120 instead of going directly to the manual quenching system 112. Again, the pressure plate 122 may be used to activate or actuate the switches 118.

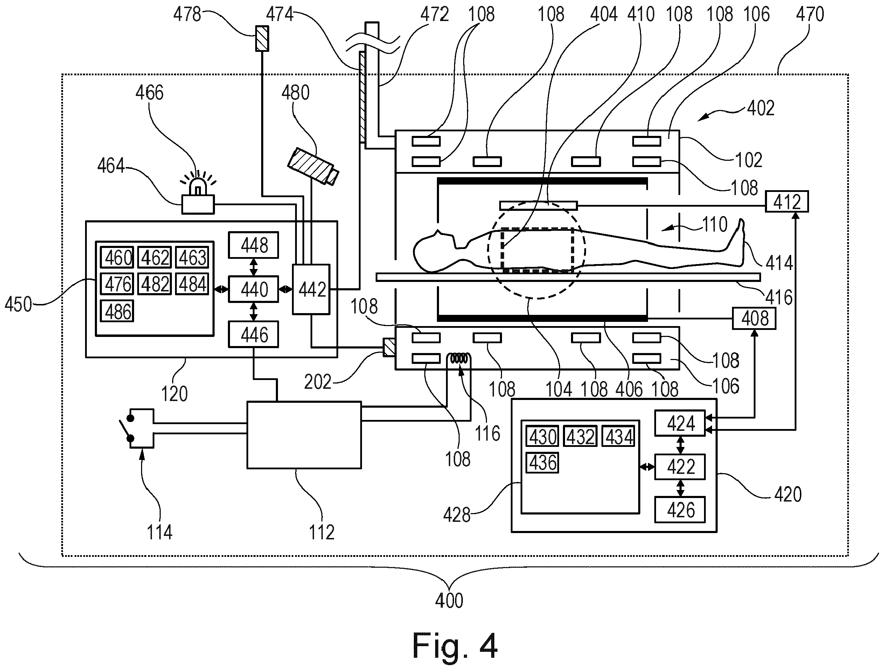

Fig. 4 illustrates a further example of a medical system 400. The medical system 400 is similar to that depicted in Fig. 2. It comprises a number of additional components. The medical system 400 is shown as further comprising a magnetic resonance imaging system 402. The magnetic resonance imaging system comprises the magnetic resonance imaging magnet 102.

The magnetic resonance imaging magnet 102 is a superconducting cylindrical type magnet with a bore 110 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 110 of the cylindrical magnetic resonance imaging magnet 102 there is an imaging zone 104, which as was described earlier is where the magnetic field is strong and uniform enough to perform magnetic resonance imaging. A field of view 404 is shown within the imaging zone 104. The k-space data that is acquired typically acquried for the field of view 404. A subject 414 is shown as being supported by a subject support 416 such that at least a portion of the subject 414 is within the imaging zone 104 and the field of view 404.

Within the bore 110 of the magnet there is also a set of magnetic field gradient coils 406 which is used for acquisition of preliminary magnetic resonance data to spatially encode magnetic spins within the imaging zone 110 of the magnetic resonance imaging magnet 102. The magnetic field gradient coils 406 connected to a magnetic field gradient coil power supply 408. The magnetic field gradient coils 406 are intended to be representative. Typically magnetic field gradient coils 406 contain three separate sets of coils for spatially encoding in three orthogonal spatial directions. A magnetic field gradient power supply supplies current to the magnetic field gradient coils. The current supplied to the magnetic field gradient coils 406 is controlled as a function of time and may be ramped or pulsed.

Adjacent to the imaging zone 110 is a radio-frequency coil 410 for manipulating the orientations of magnetic spins within the imaging zone 110 and for receiving radio transmissions from spins also within the imaging zone 108. The radio frequency antenna may contain multiple coil elements. The radio frequency antenna may also be referred to as a channel or antenna. The radio-frequency coil 410 is connected to a radio frequency transceiver 412. The radio-frequency coil 410 and radio frequency transceiver 412 may be replaced by separate transmit and receive coils and a separate transmitter and receiver. It is understood that the radio-frequency coil 410 and the radio frequency transceiver 412 are representative. The radio-frequency coil 410 is intended to also represent a dedicated transmit antenna and a dedicated receive antenna. Likewise the transceiver 412 may also represent a separate transmitter and receivers. The radio-frequency coil 410 may also have multiple receive/transmit elements and the radio frequency transceiver 412 may have multiple receive/transmit channels. For example if a parallel imaging technique such as SENSE is performed, the radio-frequency coil 410 will have multiple coil elements used to record k-space data.

The medical system 400 is further shown as comprising a computer 420 which is configured for controlling the magnetic resonance imaging system 402. The computer 420 comprises a main computational system 422 that is in communication with a hardware interface 424. The hardware interface 424 enables the computational system 422 to receive data as well as to control other components such as the transceiver 412 and the magnetic field gradient coil power supply 408.

The main computational system 422 is shown as further being in communication with an optional user interface 426. The optional user interface 426 may enable an operator to control the operation and function of the magnetic resonance imaging system 402. The computer 420 is further shown as containing a main memory 428 which is in communication with the main computational system 422. The main memory 428 is intended to represent various types of memory which may be accessible to the main computational system 422.

The main memory 428 is shown as containing main machine-executable instructions 430. The main machine-executable instructions 430 may enable the main computational system 422 to perform basic control commands for the magnetic resonance imaging system 402 as well as to perform numerical and image reconstruction tasks. The main memory 428 is further shown as containing pulse sequence commands 432. The pulse sequence commands 432 are commands or data which may be converted into commands to control the magnetic resonance imaging system 402 to acquire k-space data. The main memory 428 is further shown as containing k-space data 434 that was acquired by controlling the magnetic resonance imaging system 402 with the pulse sequence commands 432. The main memory 428 is further shown as containing a magnetic resonance image 436 that was optionally reconstructed from the k-space data 434.

In Fig. 4 additional details descriptive of the automated quenching system 120 are shown. In this example the automated quenching system 120 is further shown as containing a local computational system 440. The local computational system 440 is shown as being connected to its own hardware interface 442. The hardware interface 442 for example enables the local computational system 440 to receive sensor data. The sensor package 202 is shown as being connected to the hardware interface 442. The local computational system 440 is further shown as being connected to an optional data interface 448. The local computational system 440 is further shown as being connected to a trigger electronics 446 which are configured for triggering the manual quenching system 112. In some instances the trigger electronics 446 are identical with the hardware interface 442.

The local computational system 440 is shown as being connected with a local memory 450. The local memory 450 is memory which is accessible to the local computational system 440. This may be a combination of volatile and non-volatile memory. The local memory 450 is further shown as containing local machine-executable instructions 460. These enable the local computational system 440 to perform basic numerical and control tasks. The local memory 450 is further shown as containing pre-programmed trigger criterion 462. The local memory 450 is further shown as containing sensor data 463 that was obtained from various sensors connected to the hardware interface 442.

The hardware interface 442 is further shown as being connected to an optional test mode controller 464. The optional test mode controller 464 is configured to deactivate the trigger electronics 446 so that it is no longer able to trigger the manual quenching system 112. The test mode controller 464 may optionally comprise a test mode indicator 446 that is configured to provide a signal or indication when the automated quenching system 120 tries to trigger the manual quenching system 112 but is disabled by the test mode controller 464.

In this example the medical system 400 is located within an examination room 470. A venting duct 472 is shown as being connected to the cryogenic chamber 106. The venting duct 472 is designed to take potentially hazardous gases produced during the quenching of the magnet 102 out of the examination room 470. In the event of an earthquake or other event the venting duct 472 could become damaged and no longer be able to vent gases out of the examination room 470. Shown as being attached to the venting duct 472 is a venting duct integrity detector 474. If the venting duct 472 is mechanically damaged the venting duct integrity detector 474 is also damaged which causes it to send a duct signal 476.

The duct signal 476 is used to indicate a functional or non-functional status of the venting duct 472. The duct signal 476 is an example of the sensor data 463. The duct signal 476 is also shown as being stored in the local memory 450. The medical system 400 is further shown as comprising an external sensor 478. The external sensor 478 is configured to provide sensor data 463 that originates outside of the examination room 470. For example, the external sensor 478 may be connected to a fire alarm or other emergency alarm for a building the medical system 400 is located in. The external sensor 478 could also monitor the power status of the building. For example, it may be able to monitor the status of power being supplied to the building as well as the status of emergency backup power.

As a further example of a sensor, a camera 480 is shown. The camera 480 is configured to acquire image data 482 from within the examination room 470. In this example it is imaging a part of the bore 110 of the magnet 102 and is used to detect the presence of the subject 414 in the magnet 102. The local memory 450 is further shown as containing image data 482 that has been acquired by the camera 480. The local memory 450 is further shown as containing a subject recognition module 484. The subject recognition module 484 may for example be a module which is configured to acquire anatomical key points descriptive of the subject's 414 position or it may also be a module which is configured to just recognize the presence of a human or subject 414 in the image data 482. This may for example be a convolutional neural network which has been trained to recognize a subject 414 or human in the image data 482.

The memory 450 is shown as further containing an identification 486 of the subject 414 in the magnet 102. This may represent a status of the medical system 400. The image data 482 is another example of sensor data 463. Various types of sensors may be combined to determine if it is safe to vent or quench the magnet 102. For example, if the venting duct integrity detector 474 indicates that the vent 472 may be mechanically damaged and the camera 480 represents that before the event occurred a subject 414 was in the bore of the magnet 110 it may disable the quenching of the magnet 102.

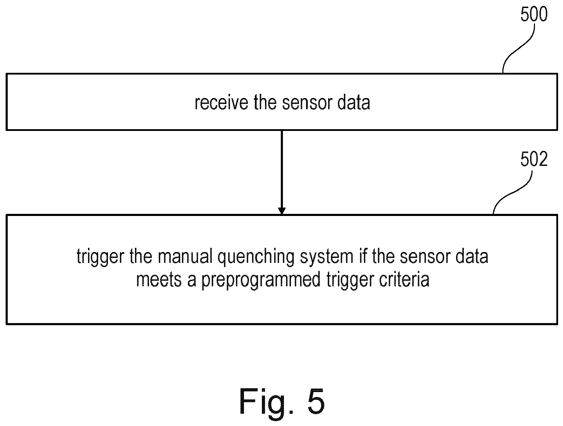

Fig. 5 shows a flowchart which illustrates a method of operating the medical system 200 of Fig. 2, medical system 300 of Fig. 3, or medical system 400 of Fig. 4. First, in step 500, the sensor data 463 is received. Next, in step 502, the automated quenching system 120 triggers the manual quenching system 112 if the sensor data 463 meets the pre-programmed trigger criterion 463.

The pre-programmed trigger criterion 463 as well as the local machine-executable instructions 460 may be optionally updated using the data interface 448.

A security feature of the medical system 400 illustrated in Fig. 4 is that the computer 420 and the automated quenching system 120 are shown as being independent. In some cases, the automated quenching system 120 may be isolated so that it is not connected to the computer 420 as well as various networks such as the internet or any Wi-Fi, Bluetooth or other communication networks. This may prevent someone from maliciously triggering the automated quenching system remotely.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: magnetic resonance imaging magnet
- 104: imaging zone
- 106: cryogenic chamber
- 108: superconducting coil
- 110: bore of magnet
- 112: manual quenching system
- 114: manual switch
- 116: heater
- 118: switch
- 119: top portion of magnet
- 120: automated quenching system
- 122: pressure plate
- 200: medical system
- 202: sensor package
- 300: medical system
- 400: medical system
- 402: magnetic resonance imaging system
- 404: field of view
- 406: magnetic field gradient coils
- 408: magnetic field gradient coil power supply
- 410: radio-frequency coil
- 412: transceiver
- 414: subject
- 416: subject support
- 420: computer
- 422: main computational system
- 424: hardware interface
- 426: optional user interface
- 428: main memory
- 430: main machine executable instructions
- 432: pulse sequence commands
- 434: k-space data
- 436: magnetic resonance image
- 440: local computational system
- 442: hardware interface
- 446: trigger electronics
- 448: optional data interface
- 450: local memory
- 460: local machine executable instructions
- 462: preprogrammed trigger criterion
- 463: sensor data
- 464: optional test mode controller
- 466: optional test mode indicator
- 470: examination room
- 472: venting duct
- 474: venting duct integrity detector
- 476: duct signal
- 478: external sensor
- 480: camera
- 482: image data
- 484: subject recognition module
- 486: identification of human in magnet
- 500: receive the sensor data
- 502: trigger the manual quenching system if the sensor data meets a preprogrammed trigger criteria

## Claims

1. A medical system (100, 200, 300, 400) comprising:
- a magnetic resonance imaging magnet (102) configured for generating a main magnetic field with a superconducting coil (108), wherein the superconducting coil is cooled by a cryogenic chamber (106);
- a manual quenching system (112) configured for initiating a quench of the main magnetic field, wherein the manual quenching system comprises at least one manual switch (114) configured for triggering the manual quenching system;
- at least one sensor (118, 202,478, 480) configured for providing sensor data (463);
- an automated quenching system (120) configured for triggering the manual quenching system in response to receiving the sensor data.

2. The medical system of claim 1, wherein the automated quenching system further comprises a local computational system (440) and a local memory (450), wherein the local memory comprises local machine executable instructions (460), wherein execution of the local machine executable instructions further causes the local computational system to:
- receive (500) the sensor data; and
- trigger (502) the manual quenching system if the sensor data meets a preprogrammed trigger criteria (462).

3. The medical system of claim 2, wherein the automated quenching system comprises a test mode controller (464), wherein the automated quenching system is configured such that when the test mode controller is engaged triggering of the manual quenching system by the automated quenching system is disabled.

4. The medical system of claim 3, wherein the automated quenching system further comprises a test mode indicator (466), wherein the test mode indicator is configured to provide an alert when the sensor meets the preprogrammed trigger criterion and the test mode controller is engaged.

5. The medical system of claims 2, 3, or 4, wherein the automated quenching system comprises a data interface (448), wherein the data interface is configured for receiving changes to the preprogrammed trigger criteria.

6. The medical system of any one of claim 1 through 5, wherein the at least one sensor comprises a camera (480), wherein sensor data comprises image data acquired by the camera, wherein the camera is configured for imaging at least a portion of an examination room (470), wherein the local memory further comprises a subject recognition module (484) configured for identifying humans in the image data, wherein execution of the local machine executable instructions further causes the computational system to:
- receive the image data from the camera; and
- receive an identification of humans (486) in the image data by inputting the image data into the subject recognition module, wherein the predetermined criteria comprises disabling the automated quenching system if the identification of humans in the image data is received.

7. The medical system of any one of the preceding claims, wherein the at least one sensor comprises any one of the following: an accelerometer, an acoustic sensor, a smoke detector, a building power sensor, a thermal detector, a vibration sensor, a moisture sensor, and combinations thereof.

8. The medical system of any one of the preceding claims, wherein the medical system further comprises a venting duct (472) configured for venting gasses when the magnet quenches, wherein the at least one sensor comprises a venting duct integrity detector (474) configured for providing a duct signal that indicates if the venting duct is functional or non-functional, wherein the automated quenching system is further configured for disabling triggering of the manual quenching system if the duct signal indicates that the venting duct is non-functional.

9. The medical system of claim 7, wherein the venting duct integrity detector comprises any one of the following:
- a fiber optic sensor comprising a fiber optic cable attached to at least a portion of the venting duct, wherein the automated quenching system is configured such that mechanical damage to the fiber optic cable causes the duct signal to change from function to non-functional; and
- a conductive loop attached to a least a portion of the venting duct, wherein the automated quenching system is configured such that a break in the conductive loop causes the duct signal to change from function to non-functional.

10. The medical system of any one of the preceding claims, wherein the medical system further comprises a magnetic resonance imaging system (402), wherein the magnetic resonance imaging system comprises the magnetic resonance imaging magnet, the manual quenching system, and the automated quenching system, wherein the magnetic resonance imaging system further comprises:
- a main memory (428) configured for storing machine executable instructions and pulse sequence commands (432), wherein the pulse sequence commands are configured to control the magnetic resonance imaging system to acquire k-space data (434);
- a main computational system (422), wherein execution of the main machine executable instructions causes the main computational system to:
- acquire the k-space data by controlling the magnetic resonance imaging system with the pulse sequence commands; and
- preferably reconstruct a magnetic resonance image (436) from the k-space data.

11. The medical system of claim 10, wherein the automated quenching system is logically isolated from the main memory and the main computational system.

12. The medical system of any one of the preceding claims wherein the at least one sensor comprises at least one switch (118) mounted on a top portion (119) of the magnet.

13. The medical system of claim 12, wherein the automated quenching system further comprises a trigger mechanism (122) mounted on the top portion of the magnet, wherein the trigger mechanism is configured to actuate the at least one switch when moved towards the magnet.

14. A computer program comprising local machine executable instructions for execution by a local computational system integrated into a medical system, wherein the medical system comprises:
- a magnetic resonance imaging magnet configured for generating a main magnetic field with a superconducting coil, wherein the superconducting coil is cooled by a cryogenic chamber;
- a manual quenching system configured for initiating a quench of the main magnetic field, wherein the manual quenching system comprises at least one manual switch configured for triggering the manual quenching system;
- at least one sensor configured for providing sensor data; and
- an automated quenching system configured for triggering the manual quenching system in response to receiving the sensor data, wherein execution of the local machine executable instructions causes the local computational system to:
- receive (500) the sensor data; and
- trigger (502) the manual quenching system if the sensor data meets a preprogrammed trigger criteria.

15. A method of operating a medical system, wherein the medical system comprises:
- a magnetic resonance imaging magnet configured for generating a main magnetic field with a superconducting coil, wherein the superconducting coil is cooled by a cryogenic chamber;
- a manual quenching system configured for initiating a quench of the main magnetic field, wherein the manual quenching system comprises at least one manual switch configured for triggering the manual quenching system;
- at least one sensor configured for providing sensor data; and
- an automated quenching system configured for triggering the manual quenching system in response to receiving the sensor data, wherein the method comprises:
- receiving (500) the sensor data; and
- triggering (502) the manual quenching system if the sensor data meets a preprogrammed trigger criteria.
